# EUROPEAN PATENT SPECIFICATION

(11) **EP 1 659 130 B1**
(45) Date of publication and mention of the grant of the patent: **31.08.2011**
(21) Application number: 04771133.8
(22) Date of filing: 02.08.2004
(51) Int. Cl.: C07F 17/00, C23C 16/18

(54) **RARE EARTH METAL COMPLEX, MATERIAL FOR THIN-FILM FORMATION, AND PROCESS FOR PRODUCING THIN FILM**
SELTENERDMETALLKOMPLEX, MATERIAL ZUR BILDUNG DÜNNER FILME UND VERFAHREN ZUR HERSTELLUNG DÜNNER FILME
COMPLEXE DE METAUX DES TERRES RARES, MATERIAU DE FORMATION DE COUCHE MINCE ET PROCEDE DE PRODUCTION DE COUCHE MINCE

(30) Priority: 25.08.2003 JP 2003299736
(43) Date of publication of application: 24.05.2006
(73) Proprietor: Adeka Corporation, Tokyo 116-8554 (JP)
(72) Inventor: YOSHINAKA, Atsuya, c/o ASAHI DENKA Co., Ltd., Tokyo 1160012 (JP); SATO, Hiroki, c/o ASAHI DENKA Co., Ltd., Tokyo 1160012 (JP); FUJIMOTO, Ryusaku, c/o ASAHI DENKA Co., Ltd., Tokyo 1160012 (JP)
(74) Representative: Forstmeyer, Dietmar
(86) International application number: PCT/JP2004/011043
(87) International publication number: WO 2005/019234

(56) References cited:
- WO-A2-02/27063
- JP-A- 2002 338 590
- JP-A- 2003 342 285
- JP-A- 2004 100 003
- US-A- 4 882 206
- WAYDA A. L.: 'Mono-, bis and tris (t-butylcyclopentadienyl) lanthanoid complexes' JOURNAL OF ORGANOMETALLIC CHEMISTRY vol. 361, no. 1, 1989, pages 73 - 78, XP002904160

## Description

### Technical Fiel

This invention relates to a novel material for thin film formation containing a rare earth metal complex having sec-butylcyclopentadiene as a ligand, and a process for forming a rare earth metal-containing thin film using the material for thin film formation. The rare earth metal complex is useful as a material for thin film formation, particularly for chemical vapor deposition (hereinafter sometimes abbreviated as CVD). A rare earth metal-containing thin film formed by using the material of the invention is useful as, for example, a member of electronic components or a member of optical communication devices using optical glass.

### Background Art

A thin film containing a rare earth metal is used as a member of electronic components, such as high dielectric constant capacitors, ferroelectric capacitors, gate insulators, and superconducting thin films, and an element of optical communication devices using optical glass, such as laser oscillators, optical fibers, optical waveguides, optical amplifiers, and optical switches.

Processes for forming a thin film for the above applications include flame hydrolysis deposition, sputtering, ion plating, MOD techniques including dipping-pyrolysis process and sol-gel process, and chemical vapor deposition. Chemical vapor deposition processes inclusive of ALD (atomic layer deposition) are the most suitable for many advantages, such as compositional controllability, excellent step coverage, suitability to large volume production, and capability of hybrid integration.

MOD and CVD processes use an organic metal compound as a precursor supplying a rare earth metal to a thin film. Having a relatively high vapor pressure, cyclopentadienyl complexes are used as a precursor particularly in processes involving vaporization. For example, Patent Document 1 discloses a CVD process using a tris(alkylcyclopentadienyl) complex of a rare earth metal. The description refers to a sec-butyl group as the alkyl group but gives no specific reference to a complex using a sec-butylcyclopentadiene nor mention of the preparation therefor, evaluation of the physical properties thereof, and thin film formation using the same. Patent Document 2 discloses a complex using an ethylcyclopentadiene having satisfactory volatility characteristics. All the proposed complexes are solid, which are inconvenient to deliver as a CVD material. Moreover, the ethylcyclopentadienyl complex of JP-A-2002-338590 leaves about 20% by mass of a volatilization residue in differential thermal analysis in argon, indicating a problem with heat resistance.

Of known tris(alkylcyclopentadienyl) complexes of a rare earth metal those which are liquid at room temperature include tris(butylcyclopentadienyl)yttrium, tris(butylcyclopentadienyl)praseodymium, and tris(butylcyclopentadienyl)erbium. However, they involve the problem that their volatility reduces with increase of molecular weight.

Patent Document 1: U.S. Patent 4,882,206
Patent Document 2: JP-A-2002-338590

### Disclosure of the Invention

### Problems to be Solved by the Invention

A problem to be solved is that we have not yet developed a material for forming a rare earth metal-containing thin film which contains a rare earth metal complex that is excellent in deliverability, heat resistance, and volatility.

An object of the present invention is to provide a -material for thin film formation containing a rare earth metal complex which rare earth metal complex is excellent in heat resistance and volatility and which is liquid, and a process for forming a thin film using the material for thin film formation.

As a result of extensive investigation, the present inventors have found that the above problem is solved by a rare earth metal complex having cyclopentadiene having introduced therein a sec-butyl group as a substituent, i.e., sec-butylcyclopentadiene as a ligand. They have reached the present invention based on this finding.

The present invention provides a material for thin film formation containing a tris(sec-butylcyclopentadienyl) complex of a rare earth metal represented by general formula (I) shown below; and a process of forming a rare earth metal-containing thin film using the material for thin film formation. 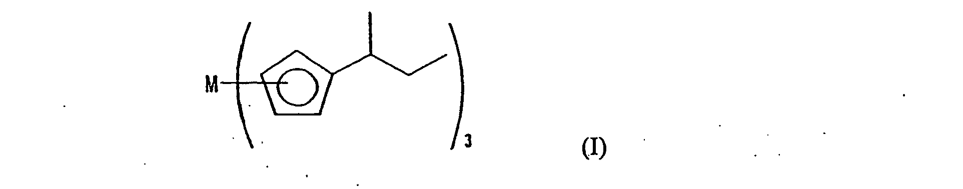 wherein M represents yttrium, praseodymium. or erbium.

### Brief Description of the Drawings

Fig. 1 is a schematic diagram illustrating an example of a CVD system that can be used to carry out the thin film formation process according to the invention.
Fig. 2 is a schematic diagram illustrating another example of a CVD system that can be used to carry out the thin film formation process according to the invention.

### Best Mode for Carrying out the Invention

General formula (I) of the present invention shown above represents a rare earth metal complex in which three sec-butylcyclopentadiene molecules are coordinated to one rare earth metal atom. While a sec-butyl group is a group having an optically active site, the formula (I) is not distinguished between an R-form and an S-form. Either an R-form or an S-form is effective. So is an R/S mixture. The rare earth metal atom represented by M includes yttrium, praseodymium, , and erbium

Compared with other known alkylcyclopentadienyl complexes, the tris(sec-butylcyclopentadienyl) complex is particularly useful as a material for CVD.
Usefulness of the tris(sec-butylcyclopentadienyl) complex as a CVD material will be discussed.

First of all, the tris(sec-butylcyclopentadienyl) complex is useful because it is liquid. In CVD and ALD, fluidity is required of the source material because a fluid material is easier to deliver. A conceivable liquid state of a material include a dissolved state of the material in an organic solvent and a molten state of the material under heating. In using a material that is solid at room temperature in either liquid state, however, it is difficult to avoid a problem of precipitation into a solid phase in a liquid source deliver system caused, e.g., by a change in feed rate.

Rare earth metal complexes having an alkyl-substituted cyclopentadienyl ligand include tris(ethylcyclopentadienyl) complexes and tris(isopropylcyclopentadienyl) complexes. The tris(ethylcyclopentadienyl) complexes, for example, Y complexes, La complexes, Pr complexes, and Er complexes have a melting point of 48° to 51°C, 93° to 95°C, 70° to 73°C, and 55° to 58°C, respectively. The tris(isopropylcyclopentadienyl) complexes, for example, Pr complexes and Er complexes have a melting point of 50° to 54°C, 63° to 65°C, respectively, and tris(isopropylcyclopentadienyl)La complex is liquid at room temperature. On the other hand, the tris(sec-butylcyclopentadienyl) complex , of whichever of Y, Pr, and Er, employed in the present invention, is liquid at room temperature.

Secondly, the tris(sec-butylcyclopentadienyl) complex is useful because it has high heat stability. A source for CVD undergoes heating when delivered and/or vaporized. If it has insufficient heat stability, the rare earth metal supply to a thin film will reduce with time, making film composition control difficult. Moreover, troubles will occur due to adhesion of decomposition products to the inside of the CVD system or contamination of the CVD system with decomposition products. In Examples given later are shown the volatilization residue of the tris(sec-butylcyclopentadienyl) complexes of the invention in TG analysis. The volatilization residues around 340°C are not more than 1% by mass, which prove that the tris(sec-butylcyclopentadienyl) complexes employed in the present invention invention volatilize without thermal decomposition.

Thirdly, the tris(sec-butylcyclopentadienyl) complex employed in the present invention is useful because of satisfactory volatility. Compared with trisbutylcyclopentadienyl complexes, which are liquid and equal in molecular weight, the tris(sec-butylcyclopentadienyl) complex employed in the present invention invention is characterized by its superior volatility.

The tris(sec-butylcyclopentadienyl) complex employed in the present invention can be prepared utilizing well-known reactions with no particular restrictions. Suitable processes for the preparation include salt exchange reaction between an alkali metal complex, e.g., sec-butylcyclopentadienylsodium or sec-butylcyclopentadienylpotassium, and a rare earth metal halide, e.g., a trichloride or a tribromide.

The material for thin film formation according to the present invention contains the aforementioned tris(sec-butylcyclopentadienyl) complex employed in the present invention as a metal source compound for thin film formation. The form of the material depends on the thin film formation technique using the material, including flame hydrolysis deposition, ion plating, MOD processes such as dipping-pyrolysis and sol-gel process, and chemical vapor deposition inclusive of ALD. The material for thin film formation of the invention is especially useful as a source of chemical vapor deposition (CVD) in view of the physical properties of the tris(sec-butylcyclopentadienyl) complex.

Where the material for thin film formation of the invention is a source for chemical vapor deposition (CVD), the form of the material is selected as appropriate to the procedures of the CVD process adopted, such as the source delivery system.

The source delivery system includes a vapor delivery system in which the material for CVD is vaporized by heating and/or pressure reduction in a chamber and introduced into a deposition reaction site, if desired, together with a carrier gas, e.g., argon, nitrogen or helium, and a liquid delivery system in which the material for CVD is carried in the form of a liquid or a solution to a vaporizer, where it is vaporized by heating and/or pressure reduction and then led to a deposition reaction site. When applied to the vapor delivery system, the tris(sec-butylcyclopentadienyl) complex of the invention per se is a material for CVD. In the case of liquid delivery system, the tris(sec-butylcyclopentadienyl) complex employed in the present invention invention per se or a solution of the complex in an organic solvent is a material for CVD.

In a multi-component CVD process, the source delivery systems are also divided into a multi-source system in which a plurality of precursors are used and a single source system using a mixture of a plurality of precursors at a prescribed ratio is used. In the case of the single source system, the material for CVD is a mixture or mixed solution containing the tris(sec-butylcyclopentadienyl) complex of the invention and other precursor(s).

The organic solvent that can be used in the material for CVD is not particularly limited, and any well-known organic solvent is useful. Examples are alcohols, such as methanol, ethanol, 2-propanol, and n-butanol; acetic esters, such as ethyl acetate, butyl acetate, and methoxyethyl acetate; ether alcohols, such as ethylene glycol monomethyl ether, ethylene glycol monoethyl ether, ethylene glycol monobutyl ether, and diethylene glycol monomethyl ether; ethers, such as tetrahydrofuran, ethylene glycol dimethyl ether, diethylene glycol dimethyl ether, triethylene glycol dimethyl ether, and dibutyl ether; ketones, such as methyl butyl ketone, methyl isobutyl ketone, ethyl butyl ketone, dipropyl ketone, diisobutyl ketone, methyl amyl ketone, cyclohexanone, and methylcyclohexanone; hydrocarbons, such as hexane, cyclohexane, methylcyclohexane, ethylcyclohexane, heptane, octane, toluene, and xylene; hydrocarbons having a cyano group, such as 1-cyanopropane, 1-cyanobutane, 1-cyanohexane, cyanocyclohexane, cyanobenzene, 1,3-dicyanopropane, 1,4-dicyanobutane, 1,6-dicyanohexane, 1,4-dicyanocyclohexane, and 1,4-dicyanobenzene; pyridine, and lutidine. A solvent or a mixture of solvents to be used is selected properly according to, for example, solubility for the solute and the boiling temperature or ignition temperature in relation to the working temperature. In using these organic solvents, the total concentration of the tris(sec-butylcyclopentadienyl) complex of the invention and other component(s) in the organic solvent is preferably 0.01 to 2.0 mol/l, still preferably 0.05 to 1.0 mol/l.

Other precursors that can be used in combination with the tris(sec-butylcyclopentadienyl) complex employed in the present invention in the multi-component CVD system are not particularly limited, and any precursors well-known in the art for use as CVD materials can be used. The amount of the other precursors to be used is determined from a desired thin film composition.

Examples of the other precursors include compounds formed between a metal and one or more organic coordinating compounds selected from alcohol compounds, glycol compounds, β-diketones, cyclopentadiene compounds, and so forth. Examples of the metal include magnesium, calcium, strontium, barium, titanium, zirconium, hafnium, vanadium, niobium, tantalum, manganese, iron, ruthenium, cobalt, rhodium, iridium, nickel, palladium, platinum, copper, silver, gold, zinc, gallium, indium, germanium, tin, lead, antimony, bismuth, and silicon.

If desired, the material for CVD can contain a nucleophilic reagent to stabilize the tris(sec-butylcyclopentadienyl) complex employed in the present invention and other precursor. Examples of suitable nucleophilic reagents include ethylene glycol ethers, such as glyme, diglyme, triglyme, and tetraglyme; crown ethers, such as 18-crown-6, dicyclohexyl-18-crown-6, 24-crown-8, dicyclohexyl-24-crown-8, and dibenzo-24-crown-8; polyamines, such as ethylenediamine, N,N'-tetramethylethylenediamine, diethylenetriamine, triethylenetetramine, tetraethylenepentamine, pentaethylenehexamine, 1,1,4,7,7-pentamethyldiethylenetriamine, and 1,1,4,7,10,10-hexamethyl-triethylenetetramine; cyclic polyamines, such as cyclam and cyclen; β-ketonic esters or β-diketones, such as methyl acetoacetate, ethyl acetoacetate, and 2-methoxyethyl acetoacetate. The nucleophilic reagent as a stabilizer is used in an amount of 0.1 to 10 mol, preferably 1 to 4 mol, per mole of the metal compound.

The process of forming a thin film according to the present invention is by chemical vapor deposition (CVD) using the material for thin film formation according to the invention as a material for CVD. CVD is a process in which a vaporized material and, if necessary, a reactive gas is/are led to a substrate (e.g., a plate) and allowed to decompose and/or react on the substrate, and the decomposition product is allowed to grow and build up in thin film form on the substrate. The process of forming a thin film according to the present invention is not particularly restricted by the method of material delivery, the mode of deposition, the film formation conditions, the film formation equipment, and the like. Any conditions and methods commonly known in the art are made use of.

The reactive gas which can be used if necessary includes oxidizing gases, such as oxygen, ozone, nitrogen dioxide, nitrogen monoxide, water vapor, and hydrogen peroxide; and reducing gases, such as hydrogen. Reactive gases that can be used to form a nitride film include organic amine compounds, such as monoalkylamines, diakylamines, trialkylamines, and alkylenediamines; hydrazine; and ammonia.

The method of material delivery includes the above-described vapor delivery system, liquid delivery system, single source system, and multi-source system.

The deposition modes include thermal CVD (only heat is used to cause the vaporized precursor or a mixture of the vaporized precursor and a reactive gas to react to deposit a film), plasma-enhanced CVD (heat and plasma are used), photo-assisted CVD (heat and light are used), photo plasma-assisted CVD (heat, light, and plasma are used), and atomic layer deposition (ALD) in which a deposition reaction of CVD is divided into elementary reaction steps so as to build up a film stepwise on a molecular level.

The film formation conditions include reaction temperature (the substrate temperature), reaction pressure, and deposition rate. The reaction temperature is preferably 160°C or higher at which the tris(sec-butylcyclopentadienyl) complex employer in the present invention reacts sufficiently, still preferably 250° to 800°C. The reaction pressure is from atmospheric pressure to 10 Pa for thermal CVD and photo-assisted CVD or from 10 to 2000 Pa for film formation using plasma. The deposition rate can be controlled by the material feed conditions (vaporizing temperature and vaporizing pressure) and the reaction temperature and pressure. Too high a deposition rate tends to result in deteriorated characteristics of the resulting thin film, and too low a deposition rate can result in poor productivity. A preferred deposition rate ranges from 0.5 to 5000 nm/min, still preferably 1 to 1000 nm/min. In the case of ALD, the film thickness is controlled by the number of cycles to reach a desired film thickness.

In the film formation process of the present invention, the resulting thin film may be subjected to annealing to obtain improved electrical characteristics. Where step coverage is required, the process can have the step of reflowing the thin film. The reflow is preferably conducted at 600° to 1200°C, still preferably 700° to 1000°C.

The material for thin film formation according to the invention and the process of thin film formation according to the invention provide a thin film of desired kind, such as oxide ceramics, nitride ceramics, and glass, in combination with appropriate selection of a precursor of other component, a reactive gas, and film forming conditions. Applications of the oxide ceramics include high dielectric constant capacitor films for semiconductors, gate insulator films for semiconductors, ferroelectric capacitor films for semiconductors, and superconducting thin films. Applications of the nitride ceramics include barrier layers for semiconductors. Applications of the glass film include optical glass applications, such as optical fibers, optical waveguides, optical amplifiers, and optical switches.

The thin films that can be formed by the invention include rare earth metal oxide films such as Ln₂O₃; rare earth metal, aluminum and/or silicon complex oxide films; rare earth metal, zirconium and/or hafnium complex oxide films; rare earth metal, silicon, and zirconium and/or hafnium complex oxide films;
rare earth metal, tantalum and/or niobium complex oxide films; rare earth metal, silicon, and tantalum and/or niobium complex oxide films; films of rare earth metal-doped ferroelectric complex oxides (e.g., lead titanate, lead zirconate titanate, bismuth titanate, and the recited complex oxides further containing silicon); rare earth metal-doped silica glass containing silicon oxide and at least one member selected from the group consisting of aluminum oxide, germanium oxide, and a titanium compound; rare earth metal-doped fluoride glass containing at least one member selected from the group consisting of zirconium fluoride, barium fluoride, lanthanum fluoride, aluminum fluoride, and sodium fluoride; and rare earth metal-doped, tellurite glass, borate glass, chalcogenite glass, sulfide glass, bismuth oxide glass, phosphosilicate glass or borosilicate glass.

### Examples

The present invention will now be illustrated in greater detail with reference to Examples and Evaluation Example, but it should be understood that the present invention is not construed as being limited thereto.

Examples 1, 3 and present examples of the tris(sec-butylcyclopentadienyl complexes employed in the present invention. Examples 5, 7 and 8 present examples of the thin film formation materials of the invention containing each of the tris(sec-butylcyclopentadienyl complexes obtained in Examples 1, 3, 4 and Reference Example 2 and examples of the film formation process of the invention using each of the film formation materials. In Evaluation Example, vapor pressure of each of the tris(sec-butylcyclopentadienyl) complexes employed in the present invention obtained in Examples 1, 3, and 4 and comparative compounds was measured.

### EXAMPLE 1

### Preparation of tris(sec-butylcyclopentadienyl)yttrium:

Into a reaction flask purged with dry argon were put 0.948 mol of sodium hydride having been thoroughly washed with hexane and 30 ml of tetrahydrofuran, and 0.948 mol of sec-butylcyclopentadiene (racemate) was added thereto dropwise at 10°C or lower. After the dropwise addition, the mixture was stirred at 30°C until gas evolution ceased to obtain a solution. The solution was cooled to 10°C or lower and added to a mixture of 0.190 mol of yttrium trichloride and 30 ml of tetrahydrofuran while cooling so that the temperature of the reaction system might not exceed 10°C. After stirring the reaction mixture at room temperature for 10 hours, the solvent was removed by evaporation. To the residue was added 600 ml of toluene, and the solid phase was separated by filtration. The filtrate was freed of the solvent by evaporation under reduced pressure and then distilled under reduced pressure by use of a light-shielding distillation apparatus. A yellow liquid weighing 39.4 g (yield: 46%) was obtained as a fraction at a vapor temperature of 169° to 175°C and 35 Pa. As a result of analyses, the yellow liquid was identified to be tris(sec-butylcyclopentadienyl)yttrium. The results of the analyses are shown below.

### Results of analyses

(1) Elemental analysis (CH: CHN analyzer; metal analysis: ICP-MS)
   C: 71.0 mass% (calcd.: 71.67 mass%); H: 8.62 mass% (calcd.: 8.69 mass%); Y: 19.5 mass% (calcd.: 19.65 mass%)
(2) Molecular weight (TOF mass spectrum): 456.5
(3) Impurity element analysis (chlorine: X-ray fluorescence analysis; sodium: ICP-MS) Cl: 100 ppm or less; Na: 37 ppb
(4) TG-DTA (Ar: 100 ml/min; temperature rise: 10°C/min; sample weight: 14.922 mg) 50% mass loss temperature: 307°C; residue at 336°C: 0.39 mass%

### REFERENCE EXAMPLE 2

### Preparation of tris(sec-butylcyclopentadienyl)lanthanum:

Into a reaction flask purged with dry argon were put 0.816 mol of sodium hydride having been thoroughly washed with hexane and 30 ml of tetrahydrofuran, and 0.816 mol of sec-butylcyclopentadiene (racemate) was added thereto dropwise at 10°C or lower. After the dropwise addition, the mixture was stirred at 30°C until gas evolution ceased to obtain a solution. The solution was cooled to 10°C or lower and added to a mixture of 0.204 mol of lanthanum trichloride and 30 ml of tetrahydrofuran while cooling so that the temperature of the reaction system might not exceed 10°C. After stirring the reaction mixture at room temperature for 30 hours, the solid phase was removed by filtration. The filtrate was freed of the solvent by evaporation under reduced pressure and then distilled under reduced pressure by use of a light-shielding distillation apparatus. A pale yellow liquid weighing 43.1 g (yield: 42%) was collected as a fraction at a vapor temperature of 205° to 207°C and 100 Pa. As a result of analyses, the pale yellow liquid was identified to be tris(sec-butylcyclopentadienyl)lanthanum. The results of the analyses are shown below.

### Results of analyses

(1) Elemental analysis (CH: CHN analyzer; metal analysis: ICP-MS)
   C: 63.9 mass% (calcd.: 64.53 mass%); H: 7.77 mass% (calcd.: 7.82 mass%); La: 27.5 mass% (calcd.: 27.64 mass%)
(2) Molecular weight (TOF mass spectrum): 502.5
(3) Impurity element analysis (chlorine: X-ray fluorescence analysis; sodium: ICP-MS) Cl: 100 ppm or less; Na: 22 ppb
(4) TG-DTA (Ar: 100 ml/min; temperature rise: 10°C/min; sample weight: 14.063 mg) 50% mass loss temperature: 301°C; residue at 334°C: 0.33 mass%

### EXAMPLE 3

### Preparation of tris(sec-butylcyclopentadienyl)praseodymium:

Into a reaction flask purged with dry argon were put 0.158 mol of sodium hydride having been thoroughly washed with hexane and 50 ml of tetrahydrofuran, and 0.158 mol of sec-butylcyclopentadiene (racemate) was added thereto dropwise at 10°C or lower. After the dropwise addition, the mixture was stirred at 30°C until gas evolution ceased to obtain a solution. The solution was cooled to 10°C or lower and added to a mixture of 0.040 mol of praseodymium trichloride and 15 ml of tetrahydrofuran while cooling so that the temperature of the reaction system might not exceed 10°C. After stirring the reaction mixture at room temperature for 10 hours, the solvent was removed by evaporation under reduced pressure. To the residue was added 100 ml of hexane, and the solid phase was removed by filtration. The filtrate was freed of the solvent by evaporation under reduced pressure and then distilled under reduced pressure by use of a light-shielding distillation apparatus. A green liquid weighing 11.3 g (yield: 56%) was collected as a fraction at a vapor temperature of 170°C and 35 Pa. As a result of analyses, the green liquid was identified to be tris(sec-butylcyclopentadienyl)praseodymium. The results of the analyses are shown below.

### Results of analyses

(1) Elemental analysis (CH: CHN analyzer; metal analysis: ICP-MS)
   C: 64.0 mass% (calcd.: 64.28 mass%); H: 7.71 mass% (calcd.: 7.79 mass%); Pr: 27.7 mass% (calcd.: 27.93 mass%)
(2) Molecular weight (TOF mass spectrum): 504.5
(3) Impurity element analysis (chlorine: X-ray fluorescence analysis; sodium: ICP-MS) Cl: 100 ppm or less; Na: 30 ppb
(4) TG-DTA (Ar: 100 ml/min; temperature rise: 10°C/min; sample weight: 14.632 mg) 50% mass loss temperature: 302°C; residue at 335°C: 0.90 mass%

### EXAMPLE 4

### Preparation of tris(sec-butylcyclopentadienyl)erbium:

Into a reaction flask purged with dry argon were put 0.158 mol of sodium hydride having been thoroughly washed with hexane and 50 ml of tetrahydrofuran, and 0.158 mol of sec-butylcyclopentadiene (racemate) was added thereto dropwise at 10°C or lower. After the dropwise addition, the mixture was stirred at 30°C until gas evolution ceased to obtain a reaction mixture. The reaction mixture was cooled to 10°C or lower and added to a mixture of 0.040 mol of erbium trichloride and 15 ml of tetrahydrofuran while cooling so that the temperature of the reaction system might not exceed 10°C. After stirring the reaction mixture at room temperature for 30 hours, the solvent was removed by evaporation. To the residue was added 50 ml of hexane, and the solid phase was removed by filtration. The filtrate was freed of the solvent by evaporation under reduced pressure and then distilled under reduced pressure by use of a light-shielding distillation apparatus. A brown liquid weighing 8.24 g (yield: 39%) was collected as a fraction at a vapor temperature of 175°C and 40 Pa. As a result of analyses, the brown liquid was identified to be tris(sec-butylcyclopentadienyl)erbium. The results of the analyses are shown bellow.

### Results of analyses

(1) Elemental analysis (CH: CHN analyzer; metal analysis: ICP-MS)
   C: 61.0 mass% (calcd.: 61.09 mass%); H: 7.26 mass% (calcd.: 7.40 mass%); Er: 31.4 mass% (calcd.: 31.51 mass%)
(2) Molecular weight (TOF mass spectrum): 530.9
(3) Impurity element analysis (chlorine: X-ray fluorescence analysis; sodium: ICP-MS) Cl: 100 ppm or less; Na: 44 ppb
(4) TG-DTA (Ar: 100 ml/min; temperature rise: 10°C/min; sample weight: 13.597 mg) 50% mass loss temperature: 309°C; residue at 340°C: 0.99 mass%

### EVALUATION EXAMPLE

Each of the complexes obtained in Examples 1, 3, and 4 and comparative compounds 1 to 4 which are liquid at room temperature and equal in molecular weight to the corresponding complexes of the invention was measured for vapor pressure. Vapor pressure measurement was carried out by measuring the saturated vapor temperature near the liquid surface under a fixed pressure. The results obtained are shown in Tables 1 through 3.

**TABLE 1**

| Comparison of Yttrium Complexes | |
|---|---|
| Rare Earth Metal Complex | Vapor Pressure (Pa/°C) |
| Tris(s-butylcyclopentadienyl)yttrium (Example 1) | 35/173 |
| Tris(butylcyclopentadienyl)yttrium (comparative compound 1) | 35/183 |
| Tris(isobutylcyclopentadienyl)yttrium (comparative compound 2) | 35/178 |

**TABLE 2**

| Comparison of Praseodymium Complexes | |
|---|---|
| Rare Earth Metal Complex | Vapor Pressure (Pa/°C) |
| Tris(s-butylcyclopentadienyl)praseodymium (Example 3) | 30/168 |
| Tris(butylcyclopentadienyl)praseodymium (comparative compound 3) | 30/180 |

**TABLE 3**

| Comparison of Erbium Complexes | |
|---|---|
| Rare Earth Metal Complex | Vapor Pressure (Pa/°C) |
| Tris(s-butylcyclopentadienyl)erbium (Example 4) | 30/166 |
| Tris(butylcyclopentadienyl)erbium (comparative compound 4) | 14/230 |

### EXAMPLE 5

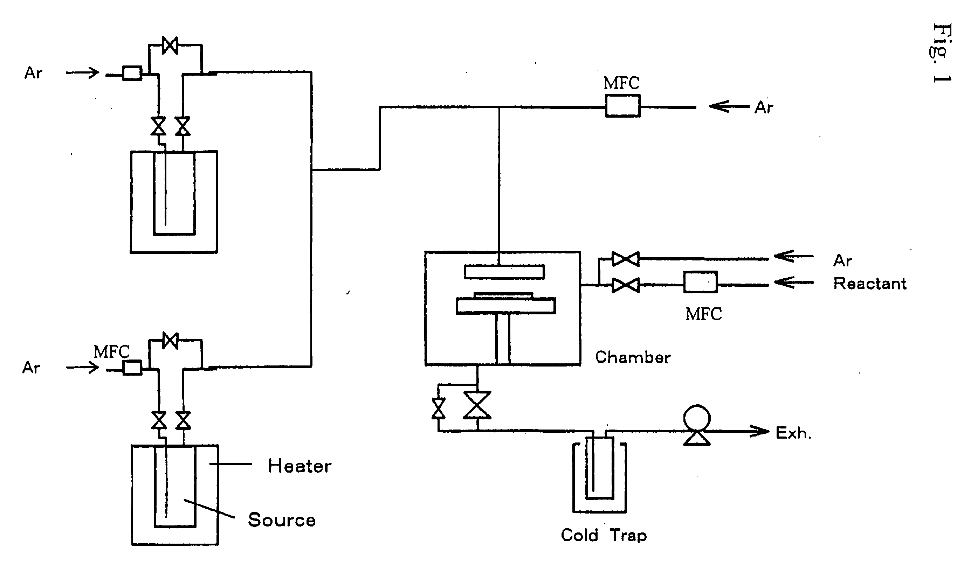

An yttrium-silicon complex oxide thin film was formed on a silicon wafer using the CVD system shown in Fig. 1 under the following conditions. The thin film was measured for thickness and composition by X-ray fluorescence analysis. The results of measurement are shown below.

### (Film formation conditions)

Yttrium source: tris(sec-butylcyclopentadienyl)yttrium obtained in Example 1 (source temperature: 180°C; pressure: 100 to 200 Pa; carrier gas: 200 sccm argon)

Silicon source: tri(dimethylamino)silane (source temperature: 20°C; pressure:
0.1 MPa; carrier gas: 35 sccm argon)
   Oxidizing gas: 50 sccm oxygen
   Reaction pressure: 660 Pa
   Reaction temperature: 450°C
   Film forming time: 2 min
(Results of measurement)
   Film thickness: 24 nm
   Composition (by mole): Y/Si=1.00/1.06

### REFERENCE EXAMPLE 6

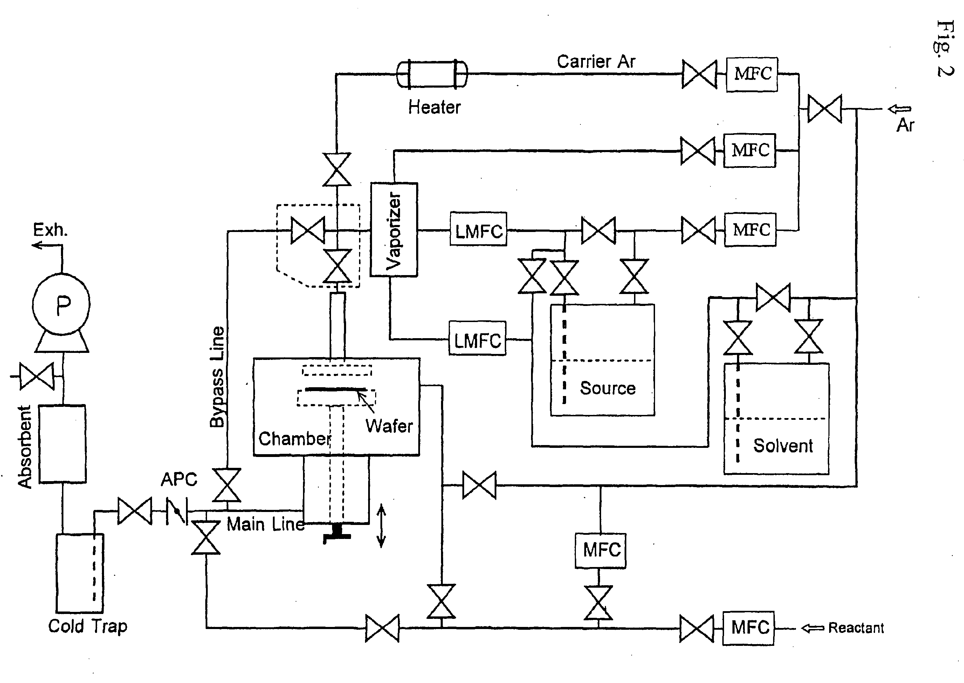

Tetrahydropyran was dried over metallic sodium wire and purified by distillation in an argon stream. The initial 10 mass% fraction and the final 10 mass% fraction were discarded to obtain a solvent with a water content less than 1 ppm. To 500 ml of the thus prepared solvent were added 0.010 mol of the tris(sec-butylcyclopentadienyl)lanthanum obtained in Example 2 and 0.04 mol of tetrakis(1,1-dimethyl-2-methoxyethoxy)hafnium in an argon stream to prepare a CVD material. A lanthanum-hafnium complex oxide film was formed on a silicon wafer using the resulting CVD material by the use of the CVD system shown in Fig. 2 under the following conditions. The resulting thin film was analyzed in the same manner as in Example 1. The results are shown below.

### (Film formation conditions)

Vaporizer temperature: 195°C
CVD material flow rate: 20 mg/min
Oxygen gas flow rate: 200 sccm
Reaction pressure: 1000 Pa
Reaction time: 2 mins
Substrate temperature: 450°C
Carrier Ar gas: 200 sccm

### (Results of measurement)

Film thickness: 21 nm
Composition (by mole): La/Hf=1.00/3.87

### EXAMPLE 7

Ethylcyclohexane was dried over metallic sodium wire and purified by distillation in an argon stream. The initial 10 mass% fraction and the final 10 mass% fraction were discarded to obtain a solvent with a water content less than 1 ppm. To 500 ml of the thus prepared solvent was added 0.250 mol of the tris(sec-butylcyclopentadienyl)praseodymium obtained in Example 3 in an argon stream to prepare a CVD material. A thin film was formed using the resulting CVD material by the use of the CVD system shown in Fig. 2 under the following conditions and in accordance with the following steps. The resulting thin film was analyzed in the same manner as in Example 1. The results are shown below.

### (Film formation conditions)

Reaction temperature (substrate temperature): 450°C
Reactive gas: water vapor

### (Steps)

A series of steps (1) through (4) below, which make one cycle, were repeated 100 times (cycles). Finally, the film formed was annealed at 600°C for 3 minutes.
(1) The CVD material vaporized under conditions of a vaporizer temperature of 195°C, a material flow rate of 20 mg/min, and a vaporizer pressure of 100 Pa was introduced into the vacuum chamber and deposited under 100 Pa for 1 second.
(2) The chamber was purged with argon for 2 seconds to expel any unreacted material.
(3) Water vapor was introduced to cause reaction under 100 Pa for 1 second.
(4) The chamber was purged with argon for 2 seconds to remove any unreacted material.

### (Results of measurement)

Film thickness: 16 nm

### EXAMPLE 8

Ethylcyclohexane was dried over metallic sodium wire and purified by distillation in an argon stream. The initial 10 mass% fraction and the final 10 mass% fraction were discarded to obtain a solvent with a water content less than 1 ppm. To 500 ml of the thus prepared solvent was added 0.250 mol of the tris(sec-butylcyclopentadienyl)erbium obtained in Example 4 in an argon stream to prepare a CVD material. A thin film was formed using the resulting CVD material by the use of the CVD system shown in Fig. 2 under the following conditions and in accordance with the following steps. The resulting thin film was analyzed in the same manner as in Example 1. The results are shown below.

### (Film formation conditions)

Reaction temperature (substrate temperature): 450°C
Reactive gas: water vapor

### (Steps)

A series of steps (1) through (4) below, which make one cycle, were repeated 40 times (cycles). Finally, the film formed was annealed at 600°C for 3 minutes.
(1) The CVD material vaporized under conditions of a vaporizer temperature of 195°C, a material flow rate of 20 mg/min, and a vaporizer pressure of 100 Pa was introduced into the vacuum chamber and deposited under 100 Pa for 1 second.
(2) The chamber was purged with argon for 2 seconds to expel any unreacted material.
(3) Water vapor was introduced to cause reaction under 100 Pa for 1 second.
(4) The chamber was purged with argon for 2 seconds to remove any unreacted material.

### (Results of measurement)

Film thickness: 7 nm

As is apparent from Examples 1, 3 and and Evaluation Example, the resulting tris(sec-butylcyclopentadienyl) complexes employed in the present invention are liquid at room temperature and excellent in heat resistance and volatility. Furthermore, Examples 5, 7 and 8 prove that the thin film forming material containing the tris(sec-butylcyclopentadienyl) complex employed in the present invention provides a thin film with satisfactory deliverability and compositional controllability when used in accordance with the thin film formation process of the invention.

### Industrial Applicability

The rare earth metal complex employed in the present invention invention, which has a sec-butylcyclopentadiene ligand, is liquid at room temperature and has satisfactory heat stability. Therefore, it is useful as a material for thin film formation, especially a material for CVD. Use of the rare earth metal complex of the invention enables establishment of a CVD process for forming a rare earth metal-containing thin film.

## Claims

1. A material for thin film formation comprising a tris(sec-butylcyclopentadienyl) complex represented by general formula (I): 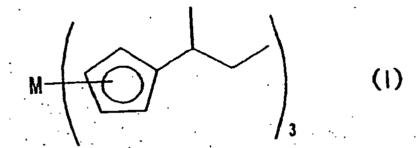 wherein M represents

2. A process of forming a thin film, comprising: vaporizing the material for thin film formation according to claim 1, introducing the resulting vapor containing the tris(sec-butylcyclopentadienyl) complex onto a substrate, and causing the tris(sec-butylcyclopentadienyl) complex to decompose and/or chemically react to form a rare earth metal-containing thin film on the substrate.

## Patentansprüche

1. Material zur Bildung eines dünnen Films, umfassend einen Tris(sec-Butylcyclopentadienyl)-Komplex, dargestellt durch die allgemeine Formel (I): 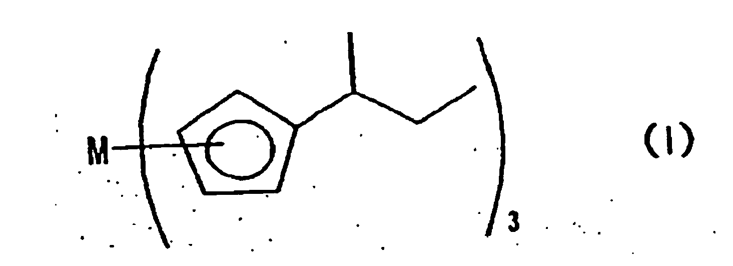 wobei M Yttrium, Praseodym, oder Erbium darstellt.

2. Verfahren zur Herstellung eines dünnen Films, umfassend: Verdampfen des Materials zur Bildung eines dünnen Films gemäß Anspruch 1, Aufbringen des resultierenden Dampfes, enthaltend den Tris(sec-Butylcyclopentadienyl)-Komplex, auf ein Substrat, und Bewirken, dass sich der Tris(sec-Butylcyclopentadienyl)-Komplex zersetzt und/oder chemisch reagiert, um einen dünnen Film, der ein Seltenerdmetall enthält, auf dem Substrat zu bilden.

## Revendications

1. Matériau pour la formation d'un film mince comprenant un complexe tri(sec-butyl)cyclopentadiényle représenté par la formule générale (I) : 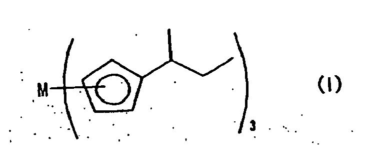 dans laquelle M représente un atome d'yttrium, de praséodyme, ou d'erbium.

2. Processus de formation d'un film mince, comprenant les étapes suivantes: vaporiser le matériau pour la formation d'un film mince selon la revendication 1, introduire la vapeur résultante contenant le complexe tri(sec-butyl)cyclopentadiényle sur un substrat, et amener le complexe tri(sec-butyl)cyclopentadiényle à se décomposer et/ou à réagir chimiquement pour former un film mince contenant un métal de terre rare sur le substrat.
